Europäisches Patentamt

European Patent Office

Office européen des brevets

(19)

(11) Publication number: **0 051 343**
**B1**

(12) **EUROPEAN PATENT SPECIFICATION**

(45) Date of publication of patent specification: **12.02.86**

(21) Application number: **81201240.9**

(22) Date of filing: **02.11.81**

(51) Int. Cl.⁴: **H 03 K 5/08,** G 11 B 7/00,
G 11 B 23/00

(54) Signal processing for digital optical disc players.

(30) Priority: **03.11.80 US 203100**

(43) Date of publication of application:
**12.05.82 Bulletin 82/19**

(45) Publication of the grant of the patent:
**12.02.86 Bulletin 86/07**

(84) Designated Contracting States:
**DE FR GB**

(56) References cited:
**DE-A-2 163 247**
**DE-A-2 208 310**
**US-A-3 588 714**

(73) Proprietor: **North American Philips Corporation**
**100 East 42nd Street 9th Floor**
**New York, N.Y. 10017 (US)**

(72) Inventor: **Chan, Albert Yiu-Cheung**
**c/o INT. OCTROOIBUREAU B.V. Prof. Holstlaan 6**
**NL-5656 AA Eindhoven (NL)**

(74) Representative: **Beckers, Hubertus Franciscus**
**Maria et al**
**INTERNATIONAAL OCTROOIBUREAU B.V. Prof.**
**Holstlaan 6**
**NL-5656 AA Eindhoven (NL)**

Courier Press, Leamington Spa, England.

## Description

This invention relates to signal processors. More particularly, this invention relates to a signal processor having means for converting an analog signal into a digital signal with minimum bias distortion.

Background of the invention

A simple optical disc recorder/player may employ a first laser light to write data on an optical disc by burning holes or pits in the medium of the spinning disc. A second laser light recorder/player is usually employed to read the recorded data by reflecting light from the disc in places where a hole or pit has been burned away during recording. The reflected light passing through a set of optics is then applied to a photodetector array where the signals are detected and processed for subsequent utilization.

The playback signal from the optical disc is derived from a laser which has a finite beam size and is proportional to the convolution of the beam and the pits along the tracks of the optical disc. As the minimum pit size in the disc approaches the diameter of the laser beam, the pulse width of the recovered signal approaches the rise time, and the recovered signal approaches the shape of a sinusoidal wave. This signal is mixed with a very low frequency aperiodic thermal drift signal and with a periodic drift-like signal caused by changes in the reflectivity of the disc material.

Theoretically, by dc-coupling and linearly amplifying the signal from the photodiode preamplifier which are elements of the photodetector array, the location of the 50% point of the recovered signal is preserved but the signal is contaminated by noise for any channel modulation code with or without dc content. The use of ac coupling causes the location of the transition of the 50% point to become distorted for a channel coded signal with dc content. The amount of distortion is directly proportional to the amount of dc content of the code.

The previously used method for converting an analog signal to a digital signal was to pass the analog signal through a low pass filter to establish an average dc level. This dc level was then applied to a comparator used as a zero crossing detector or slicer to provide a digital output signal. This method leads to inaccuracies in the disc reading apparatus because the dc content of the input signal introduces an offset in the output signal from the low pass filter resulting in timing errors in the output of the slicer. These timing errors result from the fact that the analog signal from the optical disc is mixed both with very low frequency aperiodic thermal drift and with a periodic drift-like signal caused by changes in the reflectivity of the optical disc material.

From DE—A—2208310 it is known to apply the average peak-to-peak voltage of the analog signal to a comparator used as slicer to provide a digital output signal. In this known method the slicing level varies with the said very low frequency aperiodic thermal drift.

Brief description of the invention

To correct for the timing errors and thermal drift of prior art signal processors, the present invention as claimed provides means to detect the average peak-to-peak analog signal and to pass the average of this peak-to-peak signal through a low pass filter with a cutoff above the periodic drift-like signal. The output of this filter is used as a reference voltage to a comparator which is used as a slicer and which provides a compensated digital signal output. At the same time, the average peak-to-peak signal is fed to a differential amplifier and another low pass filter having a cutoff frequency below the frequency of the periodic drift-like signal. The resulting signal is negatively fed back to the input to be summed and amplified with the input analog signal.

Brief description of the drawing

In the drawing:

Figs. 1A, 1B, and 1C show the relationship between the pit size in the optical disc and the recovered signal under ideal conditions where the pit size is greater than the laser beam diameter;

Fig. 2 shows the waveforms of an ideal signal detector in which the rise and fall times of the output signal have steep slopes;

Fig. 3 shows waveforms of a Miller code signal as effected by the high pass filter;

Fig. 4A shows waveforms of ac coupling versus dc coupling, Fig. 4B is an expanded view of the area A of Fig. 4A;

Fig. 5 shows a schematic of the static threshold detector;

Fig. 6 shows the recovered signal amplitude fluctuation caused by variation in the disc reflectivity;

Fig. 7 is a block diagram of the dc coupled signal processor of the invention;

Fig. 8 shows the waveforms, the input analog signals, the compensated analog signal and the output digital signal of the dc coupled signal processor;

Fig. 9 is a block diagram of a signal processor similar to Fig. 8 with the addition of a gap detector, a timing circuit and a selection circuit for playing back a pregrooved optical disc; and

Fig. 10 shows the waveforms generated by the timing circuit and the sector gap of the signal processor of Fig. 9.

Description of the preferred embodiments

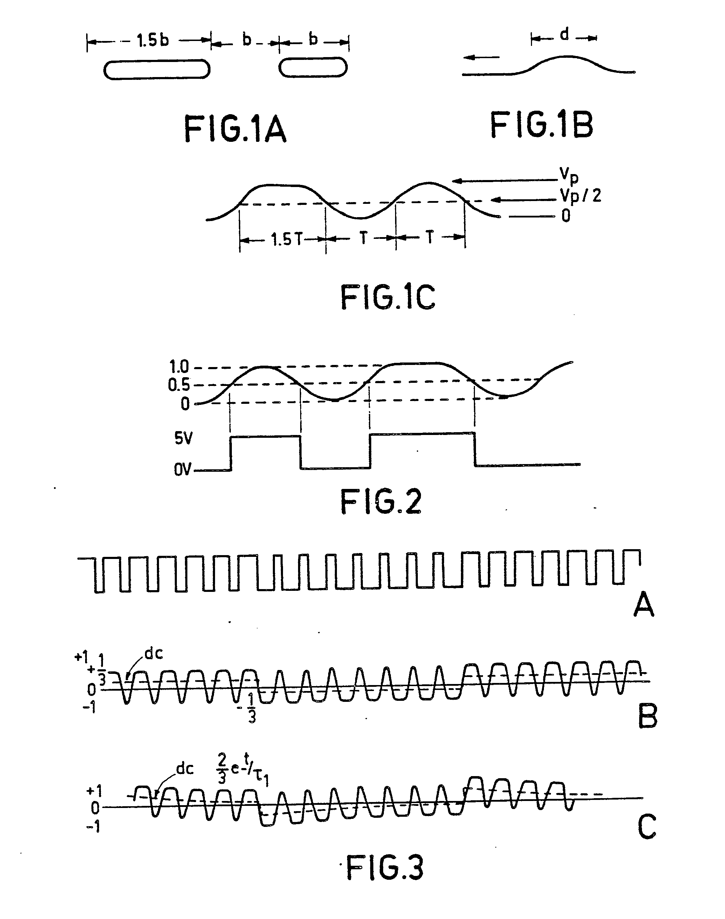

Referring to Figs. 1A, 1B and 1C, the size of the pit burned into the optical disc during recording is shown in Fig. 1A. As shown in Fig. 1A, the digital information is encoded at the halfway transition point of the recorded signal. Fig. 1B shows the diameter of the laser beam. Fig. 1C shows that as the laser beam approaches the minimum pit size the pulse width of the recovered signal approaches the rise time causing the recovered signal to approach the shape of a sinusoidal wave. This is undesirable because the output signal from the signal processor becomes distorted.

Fig. 2 shows an ideal signal detector circuit which generates a TTL compatible digital signal from recovered signals. Of course, the ideal detector cannot be achieved and it is the purpose of the present invention to approach a signal output which closely resembles the ideal signal detector.

An analysis of the amount of bias distortion in a signal processor for a Miller modulated signal is discussed below with the description of a static dc coupled threshold detector and a dynamic dc coupled threshold detector. Bias distortion in the environment of a signal processor may be defined as the amount of lengthening or shortening of the output digital pulse caused by deviations of the threshold level away from the half amplitude level of the analog input signal.

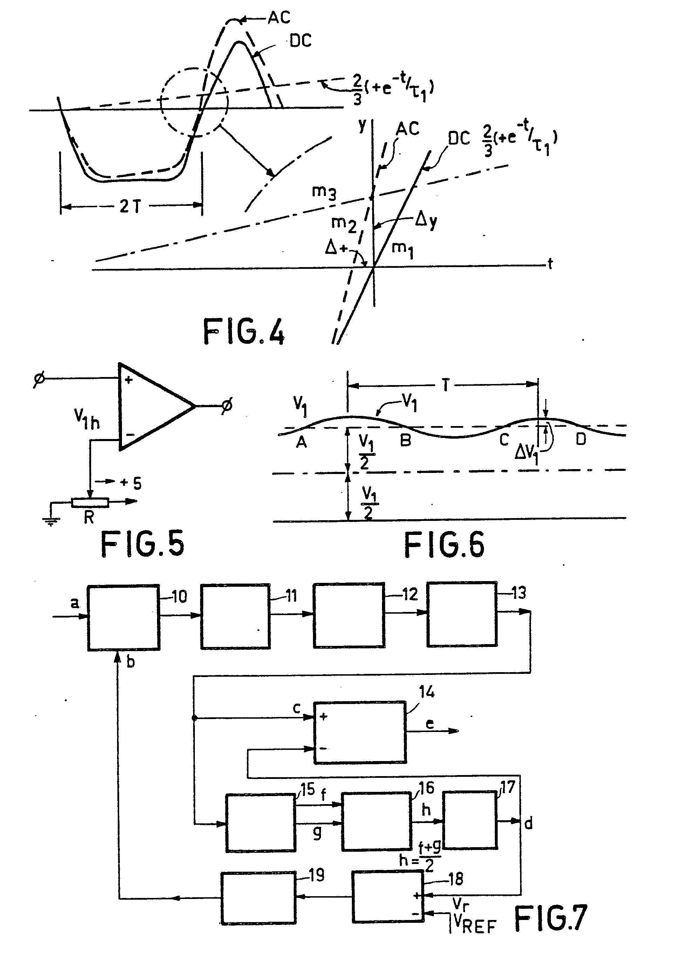

In Fig. 3, waveform A shows a signal at the Miller Modulator output with maximum dc content. Waveform B is the dc coupled normalized playback signal after amplification and equalization. The dc content of the signal is shown by dashed lines at $\pm 1/3$ amplitude of the signal. The content of an ac signal is defined as the average voltage of the signal. The effect of the high pass filter on waveform B is shown in waveform C where $\tau_l$ is the time constant of the high pass filter, having low frequency cutoff of $f_n = (2\pi\tau_l)^{-1}$. For the purpose of analysis and for deriving a formula for calculating edge distortion of the Miller signal, one cycle of the signal is shown for ac and dc coupling in Fig. 4(a). An expanded view of the area A is shown in Fig. 4(b). By analyzing the right-angle triangle formed by line ac with the y and t coordinates, $\Delta t$, the amount of distortion at the transition can be calculated.

The slope $M_1$ of line DC can be approximated by

$$M_1 \simeq \frac{2A}{t_r}$$

where A is the peak amplitude of the dc coupled playback signal, and $t_r$ is its rise time. The slope ($M_2$) of the line AC can be calculated

$$M_2 = M_1 + M_3,$$

where $M_3$ is the slope of dc content at the output of the high pass filter,

$$M_3 = \frac{d}{dt}[\frac{2}{3}(-e-t/\tau_l)]_{t=0} = \frac{2}{3}\tau_l$$

Since $M_1$ is typically much larger than $M_3$, (e.g. for a 4 rps optical recorder, $M_1 \simeq 100 M_3$), and $M_2 \simeq M_1$. The peak transition distortion, $\Delta t$ can then be calculated

$$\Delta t = \frac{\Delta y}{M_2} \simeq \frac{\Delta y}{M_1}$$

$$= \frac{\Delta y^{tr}}{2A} \simeq \frac{t_r}{2A}\frac{2}{3}A(1-e-1/RC)]$$

For the Miller Signal, the pulse duration can be 1T, 1.5T or 2, therefore

$$\Delta t = \frac{t_r}{3}(1-e^{-aT/\tau_l})$$

where a=1, 1.5 or 2.

As an example, for a 4 rps optical recorder (a data rate of 1.94 Mbits) using a high pass filter of 15 kHz, with a channel bandwidth (fc) of 1 MHz, then, T=515 nsec. yielding $\Delta t$=10.8 nsec. For Miller code, the maximum transition error margin is T/4, i.e. 129 nsec, hence the 15 kHz high pass filter removes 8.4% of this margin.

A static dc coupled threshold detector consists of a voltage comparator and a threshold control as shown in Fig. 5. The threshold voltage $V_{th}$ is adjusted to the midpoint of the single ended signal $V_1$ for the detector to perform properly. Using dc amplification from the photodiodes to $V_l$, the amount of thermal drift ($\Delta vd$) of a differential pair of bipolar transistors can be calculated

$$\Delta vd \simeq A(\frac{2.2 \text{ mV}}{700}) \text{ per degree centigrade}$$

temperature change of the photodiode, where A=voltage amplification from photodiodes to $V_l$. As an example, let the useful signal from the photodiodes by I m Vp−p, with A=700, then $V_l$=700 mVp−p, and $\Delta vd \simeq 2.2$ mV/°C.

For a 20°C temperature change ($\Delta T$), the expected drift of $V_l$ is 44 mV. Since the disc channel bandwidth is limited and the signal has a finite rise time of $t_r$, the amount of timing error ($\Delta t$) is

$$\Delta t = \frac{V_t}{V_l}(t_r) \text{ where } \Delta V_t = \text{change in threshold}$$

voltage level$= \Delta vd \times \Delta t$.

For a 4 rps optical recorder, $t_r \simeq 0.35$ usec. Then for $\Delta T$=20°C, the timing error due to thermal drift is

$$\Delta t = \frac{2.2 \times 10^{-3} \times 20}{700 \times 10^{-3}} \times 0.35 \times 10^{-6} \text{sec.} = 22 \text{ nsec.}$$

The static detector requires a readjustment of the threshold level to account for different signal amplitudes due to disc to disc and player to player variation.

Further, even for the same disc, the reflectivity varies from one angular position to another, causing amplitude variation at the disc rotational rate. As shown in Fig. 6, timing error occurs everywhere except where the threshold is proper (A, B, C, D).

The maximum timing error is

$$\Delta t = \frac{\Delta V_l}{2V_l}(t_r)$$

where $\Delta V_l$=peak signal variation of $V_l$ as shown in Fig. 6. In summary, static dc coupled threshold detection is not useful because the timing errors re not with permissible limits.

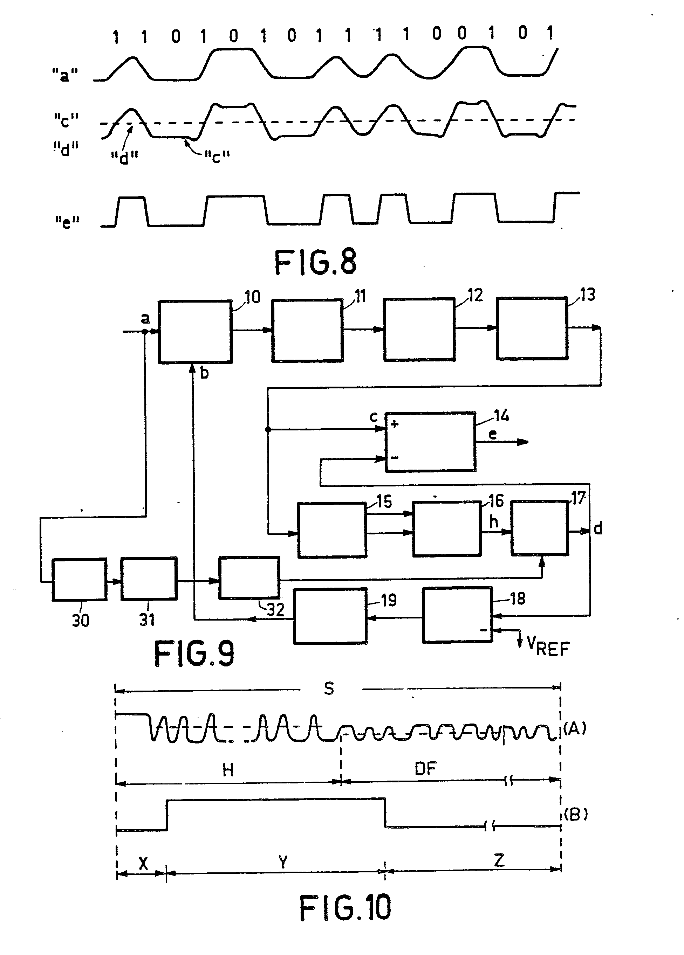

The dynamic signal dc coupled threshold detector of the invention shown in Fig. 7 automatically compensates for the thermal drift of the photodiode preamplifier and signal processor by means of a feedback loop in which the threshold voltage follows the envelope of the playback signal, thereby minimizing timing errors within permissible limits for the detector signal. In a dynamic dc coupled threshold detector there is no need for threshold voltage adjustment for different discs and players.

Input signal a applied to Summing Amplifier 10 is the analog optical disc playback signal from a dc coupled preamplifier (not shown). Also applied to Summing Amplifier 10 is input b which is a feedback signal that compensates for any thermal drift of the photodiode preamplifier and the signal processor due to temperature or aging. The summed signals a and b from Summing Amplifier 10 are fed to Linear Phase Amplitude Equalizer 11. The signal output from Linear Phase Amplitude equalizer compensates for high frequency response loss in the preceeding stages. This signal is applied to Low Pass Filter 12 in order to filter out high frequency noise. The signal is fed to Amplifier Driver 13 where it is amplified and provides an output signal c. Signal c is fed to the positive terminal of Comparator 14 and to Peak-to-Peak Detector 15. Peak-to-Peak Detector 15 tracks the positive and negative peaks of signal c and provides two signal outputs f and g. Signal f is the positive peak signal and signal g is the negative peak signal. The signals f and g are fed to Adder Divider 16 where they are added together and then divided by a factor of 2. The output signal h of Adder Divider 16 is the average of signals f and g and it is applied to Low Pass Filter 17 to be filtered. The output signal d from Low Pass Filter 17 is fed to the negative terminal of Comparator 14. Signal d is the tracking threshold signal for accurate signal detection. Comparator 14 compares signal c at its positive terminal with signal d at its negative terminal and generates a thermally compensated digital signal processor output signal e with minimum bias distortion. Signal d from Low Pass Filter 17 is also fed to the positive terminal of feedback Difference Amplifier 18. A reference voltage $V_r$ is applied to the negative terminal of Difference Amplifier 18 generating a difference signal which is then fed to Low Pass Filter 19 and then to Summing Amplifier 10 to complete the feedback channel. Low Pass Filter 19 operates at a lower frequency than Low Pass Filter 17. The slowly varying signal b is subtracted from signal a in Summing Amplifier 10.

The dc coupled signal processor of Fig. 7 operates to detect the average of the peak-to-peak analog signal c from Amplifier Driver 13 by means of Peak-to-Peak detector 15 and to pass this average peak-to-peak signal to Low Pass Filter 17 which operates at a cutoff above the periodic drift-like signal. The output of Low Pass Filter 17 is used as a reference voltage for Comparator 14 which is used as a slicer. At the same time, the output of Low Pass Filter 17 is fed to Differential Amplifier 18 with a Low Pass Filter 17 having a cutoff below the frequency of the periodic drift-like signal. This provides signal b which is negatively fed back to Summing Amplifier 10 to compensate for thermal drift. The waveforms of signals a, c, d and e are shown in Figure 11.

The choice of bandwidth of Low Pass Filter 17 needs some discussion. It should have a bandwidth larger than the disc rotational speed so that amplitude modulation due to disc reflectivity variation can be followed by tracking threshold signal d. However, Low Pass Filter 17 should have a low enough bandwidth such that signal d is not sensitive to dropouts of signal c caused by disc defects. Again, the bandwidth of Low Pass Filter 17 should be large so that the time delay of Low Pass Filter 17 is small for signal d to be a better threshold voltage when no dropout occurs. The optimal choice of bandwidth for Low Pass Filter 17 can only be determined by actual experiment. From experiments, a bandwidth of 400 Hz is a good choice for a 4RPS recorder. The threshold voltage, d, is maintained very close to $V_r$, the reference voltage, by means of the feedback path consisting of the Difference Amplifier 18, Low Pass Filter 19 and Summing Amplifier 10. Thus, all the thermal dc drift of the preamplifier and processor is automatically compensated.

Referring to Fig. 9, there is shown a signal processor essentially the same as Fig. 1 but for means added in order to playback a pregrooved disc. The blocks which are similar to the blocks in Fig. 1 retain the same reference numeral and perform as already described. In the case of playing back a pregrooved disc, the Sector Gap Detector 30 has applied to its input signal a and it generates a pulse indicating the beginning of the sector header. The output pulse from Sector Gap Detector 30 is fed to the Timing Circuit 31 which generates the correct timing pulse Y as shown in waveform B of Fig. 10. The timing pulse from timing Circuit 31 switches Low Pass Filter 17 to a higher bandwidth such that the threshold signal d can respond quickly to the signal c amplitude change at the junction between the header and data field. Signal Y should end shortly after the beginning of the data field of waveform A.

The present invention provides the advantage in that it accurately converts the readback analog signal of an optical disc from the photodiode preamplifier into a digital signal for different modulation codes with or without dc content. Further, it compensates for thermal dc drift of the photodiode preamplifier, other amplifiers, equalizer and filter. In addition, the playback signal from an optical disc is a band limited signal, having finite rise time and fall time. To convert this analog signal to a digital signal with sharp edges that carry the logical information, a stripping level at the midpoint of the signal is used. Any signal above the stripping level is converted to a logic 1 and below the stripping level to a logic zero. In the circuit, the stripping level dynamically varies with the amplitude of the readback signal. In an optical disc, the reflectivity varies across the surface of the disc generating signal amplitude modulation. Tracking the stripping level to the signal amplitude ensures accurate signal detection. Further advantages are that dropouts do not cause any problem because the stripping voltage time constant is long and at the moment a dropout is over, the voltage is charged up quickly through a very short time constant path. In the pregrooved optical disc, the header data which includes data field gap period, but sync, word sync and track address is prerecorded. During playback, the signal amplitude of the header and the data field is not the same as shown in Fig. 10. There is a step in the amplitude from the header to the data field. The circuit shown in Fig. 9 can detect the playback signal from the pregrooved disc accurately.

From the foregoing, a signal processor for digital optical disc players having means to correct an analog signal from an optical disc with finite rise time to a digital signal with accurately positioned edges by preserving the dc content of the original analog signal has been shown.

**Claims**

1. A signal processor comprising:
a source of periodically drifting analog input signals (a),
peak-to-peak voltage detecting means for deriving a tracking threshold signal (d),
means (10, 11, 12, 13) for deriving an input signal (c) from said source of analog input signals,
comparison means (14) for comparing said derived input signal (c) with said tracking threshold signal (d) for providing a digital output signal (e) with accurate positive and negative transitions by preserving the dc content of said input signal (c), characterized in that the means (10, 11, 12, 13) for deriving an input signal (c) comprise:
means (18, 19) for generating a signal (b) which compensates for thermal drift of the analog input signal(a),
means (10) for summing and amplifying the analog input signals (a) and said drift compensating signal (b) to obtain an error-compensated signal (c) as input signal for the comparison means (14), whereby the peak-to-peak voltage detecting means (15, 16, 17) receive the error-compensated signal (c) as an input signal and filter means (17, 19) comprising a first low-pass filter (17) included in said peak-to-peak voltage detecting means (15, 16, 17) with a cutoff above the cutoff of said periodically drifting analog input signal and a second low-pass filter (19) included in said means (18, 19) for generating a signal which compensates for thermal drift of the analog input signals with a cutoff above the frequency of said thermal drift and below the frequency of said periodically drifting analog input signal.

2. A signal processor as claimed in Claim 1 comprising:
means (11) responsive to said summing and amplifying means (10) for compensating for the high frequency response loss of said error compensated signal, and
means (12) responsive to said high frequency response means (11) for filtering out high frequency noise.

3. A signal processor as claimed in Claim 1 or 2 wherein said peak-to-peak detecting means (15, 16, 17) comprise:
means (15) tracking the positive and negative peaks of said analog input signal (c),
means (16) for summing and dividing said positive and negative peak signals to obtain an average of said peak-to-peak analog input signals, and
said low-pass filter (17) responsive to said summing and dividing means (16) for filtering said average peak-to-peak analog input signals above the cutoff of said periodically drifting analog input signal to provide a reference voltage to said comparing means in order to determine the digital threshold signal output.

4. A signal processor as claimed in Claim 1, 2 or 3 comprising:
a reference voltage source ($V_{REF}$),
means (18) responsive to said reference voltage source ($V_{REF}$) and said first low-pass filter (17) for providing a difference signal, and said second low-pass filter (19) for filtering said difference signal at a cutoff below the frequency of said periodic drift analog input signal to provide said feedback signal for compensating for thermal drift.

**Patentansprüche**

1. Signalaufbereiter bestehend aus einer Quelle periodisch wandernder, analoger Eingangssignale (a),
einem Spitze-zu-Spitze-Detektor zum Ableiten eines Spurnachführungs-Schwellensignals (d),
Mitteln (10, 11, 12, 13) zum Ableiten eines Eingangssignals (c) aus einer Quelle analoger Eingangssignale,
einem Komparator (14) zum Vergleichen des abgeleiteten Eingangssignals (c) mit dem Spurnachführungs-Schwellensignal (d) zum Erzeugen eines digitalen Ausgangssignals (e) mit genauen positiven und negativen Übergängen durch Erhalten des dc-Inhalts des Eingangssignals (c), dadurch gekennzeichnet, dass die Mittel (10, 11, 12, 13) zum Ableiten eines Eingangssignals (c) bestehen aus

Mitteln (18, 19) zum Erzeugen eines die thermische Abwanderung des analogen Eingangssignals (a) ausgleichenden Signals (b),

Mitteln (10) zum Summieren und Verstärken der analogen Eingangssignale (a) und des die Abwanderung ausgleichenden Signals (b) zum Erhalten eines fehlerkorrigierten Signals (c) als eines Eingangssignals zum Komparator (14), wobei der Spitze-zu-Spitze-Detektor (15, 16, 17) das fehlerkorrigierte Signal (c) als Eingangssignal empfängt, und

Filtern (17, 19) mit einem ersten, in den Spitze-zu-Spitze-Detektor (15, 16, 17) aufgenommenen Tiefpassfilter (17) mit einer Grenzfrequenz, die über der Frequenz des periodisch wandernden, analogen Eingangssignals liegt, und mit einem zweiten, in die Mittel (18, 19) zum Erzeugen eines Signals aufgenommenen Tiefpassfilter (19), in dessen Ausgangssignal das thermische Wandern der analogen Eingangssignale kompensiert ist und das eine Grenzfrequenz aufweist, die über der Frequenz der thermischen Wanderung und unterhalb der Frequenz des periodisch wandernden, analogen Eingangssignals liegt.

2. Signalaufbereiter nach Anspruch 1, dadurch gekennzeichnet, dass darin Mittel (11), die auf die Summier- und Verstärkungsmittel (10) zum Ausgleichen des Hf-Empfangsverlustes des fehlerkorrigierten Signals ansprechen, und

Mittel (12) vorgesehen sind, die auf die Hf-Empfangsmittel (11) zum Ausfiltern von Hf-Rauschen ansprechen.

3. Signalbearbeiter nach Anspruch 1 oder 2, dadurch gekennzeichnet, dass der Spitze-zu-Spitze-Detektor (15, 16, 17),

Mittel (15) zum Verfolgen der positiven und negativen Spitzen des analogen Eingangssignals (c),

Mittel (16) zum Summieren und Teilen der positiven und negativen Spitzensignale zur Erhalten eines Mittelwerts der analogen Spitze-zu-Spitze-Eingangssignale, und

das Tiefpassfilter (17) enthält, dass den Summier- und Teilungsmitteln (16) zugeordnet ist, zum Filtern der mittleren, analogen Spitze-zu-Spitze-Eingangssignale oberhalb seiner Grenzfrequenz, die über der Frequenz des periodisch wandernden, analogen Eingangssignals liegt und zum Erzeugen einer Bezugsspannung zum Komparator, um das digitale Ausgangs-Schwellensignal zu erhalten.

4. Signalaufbereiter nach Anspruch 1, 2 oder 3, dadurch gekennzeichnet, dass darin

eine Bezugsspannungsquelle ($V_{REF}$), und

Mittel (18), die der Bezugsspannungsquelle ($V_{REF}$) und dem ersten Tiefpassfilter (17) zugeordnet sind, zum Erzeugen eines Differenzsignals, und das zweite Tiefpassfilter (19) vorgesehen sind zum Filtern des Differenzsignals oberhalb einer Grenzfrequenz, die unter der Frequenz des periodisch wandernden, analogen Eingangssignals liegt, zum Erzeugen des Rückkopplungssignals für den Ausgleich der thermischen Wanderung.

**Revendications**

1. Dispositif de traitement de signaux comportant:

une source de signaux d'entrée analogiques (a) à dérive périodique,

des moyens de détection d'une tension de crête-à-crête pour déduire un signal de seuil d'alignement (d),

des moyens (10, 11, 12, 13) pour déduire un signal d'etrée (c) de ladite source de signaux d'entrée analogiques,

des moyens de comparaison (14) pour comparer ledit signal d'entrée déduit (c) avec ledit signal de seuil d'alignement (d) afin de fournir un signal de sortie numérique (e) ayant des transitions de précision positive et négatives par le maintien de la composante de courant continu dudit signal d'entrée (c), caractérisé en ce que les moyens (10, 11, 12, 13) pour déduire un signal d'entrée (c) comportent:

des moyens (19, 19) de génération d'un signal (b) compensant la dérive thermique du signal d'entrée analogique (a),

des moyens (10) servant à sommer et à amplifier les signaux d'entrée analogiques (a) et ledit signal (b) de compensation de dérive pour permettre d'obtenir un signal (c) à compensation d'erreurs comme signal d'entrée pour les moyens de comparaison (14), les moyens (15, 16, 17) de détection d'une tension de crête-à-crête recevant le signal à compensation d'erreurs comme signal d'entrée et

des moyens de filtrage (17, 19) comportant un premier filtre passe-bas (17) qui fait partie desdits moyens (15, 16, 17) de détection d'une tension de crête-à-crête et dont la fréquence de coupure est supérieure à celle dudit signal d'entrée analogique à dérive périodique, et un second filtre passe-bas (19) qui fait partie desdits moyens de génération d'un signal compensant la dérive thermique des signaux d'entrée analogiques et dont la fréquence de coupure est supérieure à la fréquence de ladite dérive thermique et inférieure à la fréquence dudit signal d'entrée analogique à dérive périodique.

2. Dispositif de traitement de signaux selon la revendication 1, comportant:

des moyens (11) influencés par lesdits moyens de sommation et d'amplification (10) et servant à compenser la perte de réponse en fréquence élevée dudit signal à compensation d'erreurs et

des moyens influencés par lesdits moyens (11) de réponse en fréquence élevée et servant à éliminer par filtrage le bruit à fréquence élevée.

3. Dispositif de traitement de signaux selon la revendication 1 ou 2, dans lequel lesdits moyens (15, 16, 17) de détection d'une tension de crête-à-crête comportent:

des moyens (15) d'alignement des crêtes positives et négatives dudit signal d'entrée analogique (c),

des moyens (16) servant à sommer et à diviser lesdits signaux à crêtes positives et négatives pour permettre d'obtenir une moyenne desdits signaux d'entrée analogiques de crête-à-crête et

ledit filtre passe-bas (17) influencé par lesdits moyens (16) de sommation et de division et servant à filtrer lesdits signaux d'entrée analogiques moyens de crête-à-crête au-dessus de la fréquence de coupure dudit signal d'entrée analogique à dérive périodique pour permettre de fournir une tension de référence auxdits moyens de comparaison afin de déterminer le signal de sortie numérique de seuil.

4. Dispositif de traitement de signaux selon la revendication 1, 2 ou 3, comportant:

une source de tension de référence ($V_{REF}$),

des moyens (18) influencés, d'une part, par ladite source de tension de référence ($V_{REF}$) et ledit premier filtre passe-bas (17) pour fournir un signal de différence et, d'autre part, par ledit second filtre passe-bas (19) pour filtrer ledit signal de différence à une fréquence de coupure inférieure à la fréquence dudit signal d'entrée analogique à dérive périodique de façon à fournir ledit signal de réaction pour la compensation de la dérive thermique.

FIG.1A

FIG.1B

FIG.1C

FIG.2

FIG.3

FIG.4

FIG.5

FIG.6

FIG.7

2

1 1 0 1 0 1 0 1 1 1 1 0 0 1 0 1

"a"

"c"
"d"

"d"    "c"

"e"

**FIG.8**

**FIG.9**

**FIG.10**

3